Europäisches Patentamt

European Patent Office

Office européen des brevets

(11) Publication number: **0 180 009**
**A2**

(12) # EUROPEAN PATENT APPLICATION

(21) Application number: **85111304.3**

(22) Date of filing: **06.09.85**

(51) Int. Cl.⁴: **H 01 L 21/285**

(30) Priority: **30.10.84 US 666581**

(43) Date of publication of application: **07.05.86**
**Bulletin 86/19**

(84) Designated Contracting States: **DE FR GB**

(71) Applicant: **International Business Machines Corporation,**
**Old Orchard Road, Armonk, N.Y. 10504 (US)**

(72) Inventor: **Sandip, Tiwari, 791 Pinesbridge Road, Ossining**
**New York 10562 (US)**

(74) Representative: **Hobbs, Francis John, IBM United**
**Kingdom Patent Operations Hursley Park, Winchester,**
**Hants, SO21 2JN (GB)**

(54) **A process of forming a contact to a compound semiconductor body.**

(57) In the formation of a contact (4) to a compound semiconductor (e.g. of GaAs or GaAlAs) body (1), a layer (2) of a metal (e.g. tantalum) is used that is capable of chemically reducing the native oxide (3) on the body. By selecting the thickness of the native oxide reducing metal layer the entire quantity of that metal can be converted to discontinuous inclusions of oxide.

A PROCESS OF FORMING A CONTACT TO A COMPOUND

SEMICONDUCTOR BODY


This invention relates to a process of forming a contact to a compound semiconductor body.


Compound semiconductor crystal materials form native oxides on their surfaces which require removal processing steps in order that an ohmic contact is formed when a metal is applied. The processing steps frequently are incompatible with device performance and reproducibility.


The presence of native oxide formation is particularly acute with the compound gallium arsenide (GaAs) and the alloys thereof such as gallium aluminum arsenide ($Ga_{1-x}Al_xAs$) and other similar compound semiconductors such as those containing aluminum, because the native oxides that occur on the surface of such compounds may be individual element oxides or mixtures having widely different properties and widely different responsiveness to removal processes.


As an example, a GaAs crystal in air at room temperature forms an oxide coating that has oxides of both arsenic and gallium. Process steps that will remove the arsenic oxide generally will not also remove the gallium oxide, and in fact temperatures that will remove the gallium oxide frequently are detrimental to the crystal periodicity or cause impurity diffusion.


In the application of metals for formation of various types of alloyed, diffused or implanted type ohmic contacts, elaborate cleaning and in-process environmental control is employed in the art to remove and to prevent further formation of oxides on compound crystals. A typical discussion of one such ohmic contact and the etching and cleaning approach required is described in J. Vac. Sci. Tech. 19, 3 Sept./Oct. 1981, p. 803 & p. 804.

In general the techniques used in the art involve etching operations or oxide decomposing operations on the bare surface which is usually a crystal accompanied by maintenance of an environment such as a vacuum to prevent further oxide formation until the metal that is to be the contact can be applied.

According to the invention, we provide a process of forming a metal contact to a compound semiconductor body comprising the successive steps of applying a layer of a native oxide reduction metal over the native oxide on a contact area of the compound semiconductor body, said native oxide reduction metal being capable of chemically reducing all the oxides in said native oxide, applying a contact metal over said layer, and heating the body to a temperature sufficient to fuse said contact metal to the body.

How the invention can be carried out will now be described by way of example, with reference to the accompanying drawings in which:-

FIG.1 is a schematic view of a compound semiconductor body provided with a nature oxide reduction metal layer and a contact metal layer;

FIG.2 is an expanded schematic view of the body of FIG.1 after heat treatment which shows discontinuous reduced oxide regions in the contact area; and

FIG.3 is a graph of resistance vs. semiconductor spacing in a common transmission line type measurement illustrating a comparison of the performance of an ohmic contact formed in accordance with the invention with that formed by a previously known process.

Compound semiconductors form oxides of the elements that are the ingredients of the compound when exposed to an oxygen containing environment, usually air.

The invention involves the use of a layer of metal that chemically reduces the native oxide on a compound semiconductor body in the formation of a contact to a device formed on the semiconductor body.

The native oxide is converted to an oxide of the metal at the interface between the compound semiconductor and the contact metal. The converted oxide becomes discontinuous as it is formed and is located mainly in the external contact metal. The thickness of the oxide reduction metal layer may be selected so that the reduction metal is completely converted to oxide in chemically reducing the native oxide.

For a compound semiconductor with a native oxide of about 5nm in thickness produced by exposure to air at room temperature a layer of a reducing metal of about 4 nm will reduce the native oxide into discontinuous reducing metal oxide inclusions at the metal-semiconductor interface.

Although it will be apparent that application of the invention will control the presence of a native oxide appearing on the surface of a compound semiconductor at any point in the processing and regardless of the type of contact being made, the description following for detailed illustration purposes will be directed to the formation of an ohmic contact.

The prescence of the native oxide either by exposure to air or formation in processing has a detrimental affect on the magnitude of any electrical current flow barrier made at the interface of a compound semiconductor and a metal. An interface with $10^{-6}$ ohm cm² specific contact resistance or 0.3 $\Omega$mm contact resistance is the type of ohmic contact required at this state of the art.

Application of the invention provides a good $10^{-6}$ ohm cm² contact to most compound semiconductor surfaces and further provides a native oxide controlling improvement to even lower resistivity contacts formed by such mechanisms as diffusion and tunneling.

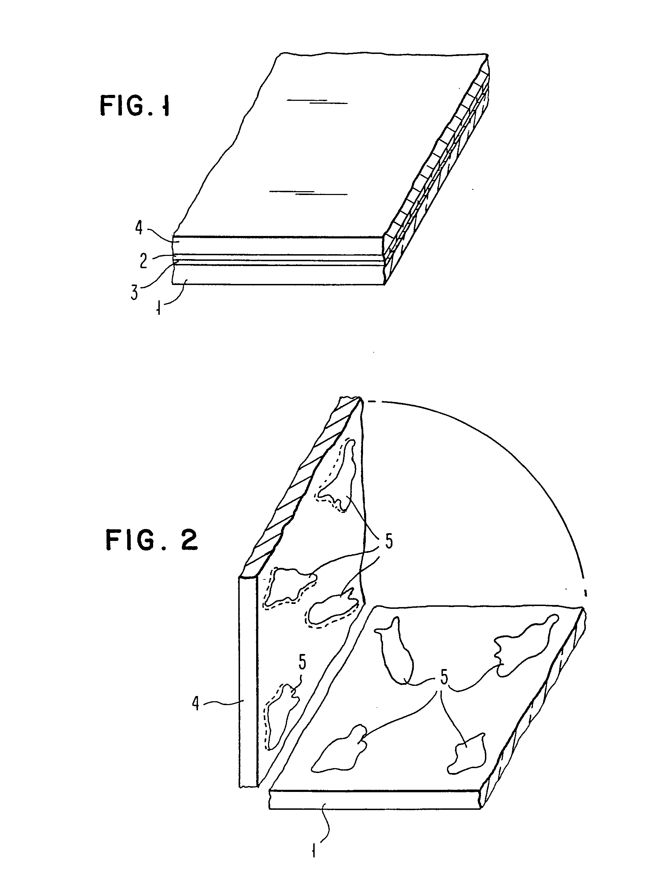

Referring to FIG.1 the compound semiconductor 1 is covered with a layer 2 of a metal that will chemically reduce the native oxide 3 that forms on the surface to permit a metal 4 to provide an electrically ohmic contact to the semiconductor 1.  The native oxide on a compound semiconductor may be an oxide of a single element, an oxide of several elements and it may even be several different oxides.  For example for the semiconductor material gallium arsenide, the native oxide may be gallium oxide and arsenic oxide.

The chemically reducing metal 2 capable of reducing the native oxide 3 is selected so that an oxide formed with the metal 2 is energetically more favorable for oxide formation than the most stable oxide present in the native oxide 3.  The metal 2, being selected to be energetically more favorable to oxide formation than any oxide or oxides in the native oxide operates to chemically reduce the native oxide and to thereby expose the uncontaminated surface of the compound semiconductor 1 to the metal 4 and thus to thereby remove the effect of any oxide on electrical conductivity and diffusion and alloying phenomena at the interface.

The metal 2 is also controlled as to thickness so that the oxide of the metal 2 that is the product of the chemical reduction of the native oxide becomes discontinuous over the area of the contact.  This permits exposure of the uncontaminated compound semiconductor 1 to the metal 4 and it permits metals to serve as the layer 2 that while they have favourable energetic relationships for reduction of native oxide, would themselves introduce disadvantageous electrical current flow barriers if the layer 2 were to be continuous over the area of the contact.

Referring next to FIG.2, a schematic illustration of the interface of the contact after the native oxide has been chemically reduced is provided.  FIG.2 uses the same reference numerals as used in FIG.1 but the contact is schematically opened to illustrate the discontinuous nature of the oxide of the metal layer 2 after chemical reduction of the native oxide 3 has taken place.  In FIG.2 the metal of the layer 2 has chemically reduced the native oxide 3 and formed a number of metal 2 oxide inclusions 5 in both the compound semiconductor 1 and mainly in the metal 4. While the inclusions occupy some small portion of the area they are not continuous and hence do not have a detrimental electrical effect and a large portion of the area of the compound semiconductor 1 is in contact with the metal 4 without contamination by native oxide.

The thickness of the layer 2 of FIG.1 is usually for ohmic contact formation selected to be such that the metal layer 2 is consumed in the forming of the oxide inclusions 5.

The reaction kinetics are made favourable to the process by providing higher thermal energy by raising the temperature of the system.

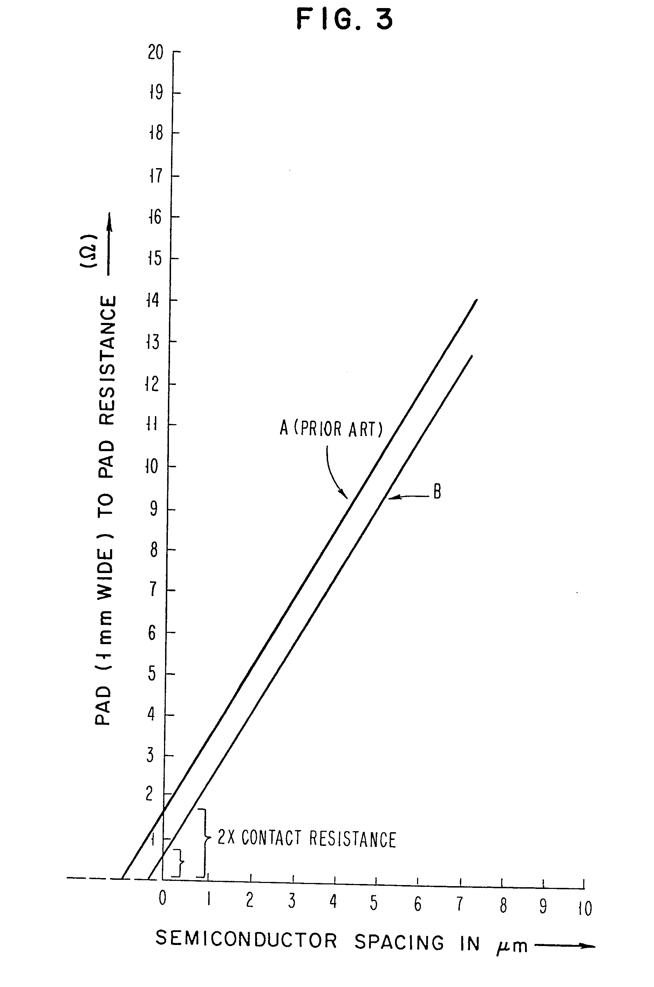

Referring to FIG.3 a comparison is provided of the performance of an ohmic contact made in accordance with the invention with respect to current (I) and voltage (V) compared with a typical prior art contact. In FIG.3 the IV performance of a AuGe alloy contact of the type described in the J. Vac. Sci. Tech. $\underline{19}$ (3) p.803 is shown as the curve labelled "A (Prior Art)". The IV performance of the contact of the invention is shown labelled "B". The performance as indicated in the graph demonstrates lower resistivity and the absence of the effect of any oxide.

While the many specific applications of the invention will be apparent, the following illustration is provided of the use of a layer 2 of tantalum on the surface of a compound semiconductor of $Ga_{1-x}Al_xAs$ using as the metal 4 AuGe, Ni, Au.

The native oxide occurring on the surface of a $Ga_{1-x}Al_xAs$ crystal may contain $Al_2O_3$, $Al_2O_3 \cdot H_2O$, $As_4O_6$, $As_2O_5$, $GaO$, $Ga_2O$ and $Ga_2O_3$. The stability of $Al_2O_3$ makes the native oxide problem for GaAlAs particularly severe.

The pertinent thermodynamic properties of these oxides are provided in Table 1 at room temperature.

Table 1

| Oxide | $\Delta H_f^\circ$ | $\Delta G_f$ | $S^\circ$ |
|---|---|---|---|
| $Al_2O_3$ | -400.5 | -378.5 | 12.17 |
| $Al_2O_3 \cdot H_2O$ | -472 | -436 | 23.15 |
| $As_4O_6$ | -313.94 | -275.36 | 51.2 |
| $As_2O_5$ | -218.6 | -184.6 | 25.2 |
| $GaO$ | 66 | - | - |
| $Ga_2O$ | - 82 | - | - |
| $Ga_2O_3$ | -222.5 | - | - |

where $\Delta H_f^\circ$ is the enthalpy of oxide formation

$\Delta G_f$ is the free energy of oxide formation and is in kilocalories per mole at constant concentration, and

$S^\circ$ is the entropy

The system is energetically favourable for oxide formation when it goes to a lower state of energy and larger numerical values for the categories of Table 1 are produced.

Tantalum will form an oxide that is energetically more favourable and hence will chemically reduce any of the oxides in Table 1 that is in the native oxide 3 on the surface including the $Al_2O_3$ components. The

tantalum oxide is $Ta_2O_5$ which has a $\Delta H_f{}^\circ$ of -489.0, a $\Delta G_f$ of -456.8 and an $S^\circ$ of 34.2 at room temperature.

In selecting the metal 2, the more energetically favourable the oxide forming reaction, a benefit will be gained in that a smaller temperature excursion will be required to effect the chemical reduction.

The thickness of the layer 2 in the case of tantalum is employed in permitting use of a metal that while it is energetically favourable for chemical reduction of the native oxide that particular metal itself has properties that could impart a different and not desired electrical conductivity.

Tantalum is well known in the art as forming a Schottky barrier contact with GaAs and the alloys thereof such as GaAlAs, and such structures are disclosed in U.S-A-4,310,570 and 4,098,921. In such structures the tantalum is used as a continuous contacting layer.

In contrast, when an ohmic contact is desired, the tantalum metal layer 2 thickness is selected in relation to the quantity of the native oxide 3. to be chemically reduced so that the entire layer 2 is converted to the $Ta_2O_5$ oxide inclusions 5 in FIG.2. A layer of about 4 nm thick is optimal for room temperature native oxide 5 nm thick conversion above 300°C.

Some thickness compensation can take place. Where the layer 2 is somewhat thicker and is not completely consumed, a higher temperature cycle, where tolerable, may be sufficient to complete the chemical reduction of the native oxide and render the layer discontinuous. As an example, where the layer 2 is 10 nm thick, a temperature cycle, of about 475°C, is required to provide ohmic contacts.

What has been described is a technique of providing a metal layer in the formation of a contact to a compound semiconductor selected to chemically reduce any native oxide on the compound semiconductor to discontinuous inclusions of metal oxide that do not interfere with electrical properties.

CLAIMS

1.  A process of forming a metal contact to a compound semiconductor
    body comprising the successive steps of applying a layer of a
    native oxide reduction metal over the native oxide on a contact
    area of the compound semiconductor body, said native oxide
    reduction metal being capable of chemically reducing all the oxides
    in said native oxide, applying a contact metal over said layer, and
    heating the body to a temperature sufficient to fuse said contact
    metal to the body.

2.  A process as claimed in claim 1, wherein said compound
    semiconductor is GaAs or GaAlAs.

3.  A process as claimed in claim 1 or claim 2, in which the thickness
    of the layer of the native oxide reduction metal is such that
    substantially all of it is converted to discontinuous oxide
    inclusions when the body is heated to fuse the contact metal
    thereto.

4.  A process as claimed in any preceding claim, in which the native
    oxide reduction metal is tantalum.

5.  A process as claimed in claim 3, in which the tantalum layer is
    approximately 4 nm thick.

6.  A process as claimed in any preceding claim, in which the contact
    metal is AuGe, Ni or Au.

**FIG. 1**

4
2
3
1

**FIG. 2**

5

5

4

5

5

1

0180009

# FIG. 3

PAD (1mm WIDE) TO PAD RESISTANCE ($\Omega$)

SEMICONDUCTOR SPACING IN $\mu$m

A (PRIOR ART)

B

2X CONTACT RESISTANCE